# EUROPEAN PATENT APPLICATION

(11) **EP 2 565 932 A1**
(43) Date of publication of application: **06.03.2013**
(21) Application number: 11189432.5
(22) Date of filing: 16.11.2011
(51) Int. Cl.: H01L 31/0216, H01L 31/0224

(54) **Solar energy cell**

(30) Priority: 01.09.2011 TW 100131533
(71) Applicant: Gintech Energy Corporation, Jhunan Township, Miaoli County 350 (TW)
(72) Inventor: Huang, Kuei-Wu, 350 Miaoli County (TW); Kuo, Ming-Chin, 350 Miaoli County (TW); Chiou, Yan-Kai, 350 Miaoli County (TW); Tsai, Ching-Tang, 350 Miaoli County (TW); Chen, Tien-Szu, 350 Miaoli County (TW)
(74) Representative: Granleese, Rhian Jane

(57) **Abstract**

A solar energy cell includes a photoelectric conversion layer (104,106), an anti-reflection layer (101) and a plurality of electrical conductive channels (102b). The anti-reflection layer is disposed on the photoelectric conversion layer. The electrical conductive channels are disposed on the anti-reflection layer and electrically connected with the photoelectric conversion layer, wherein the electrical conductive channels include a conductive paste and pigments to enable a color thereof to be substantially the same as a color of the anti-reflection layer.

## Description

### RELATED APPLICATIONS

This application claims priority to Taiwan Application Serial Number 100131533, filed September 01, 2011, which is herein incorporated by reference.

### BACKGROUND

### Field of Invention

The present invention relates to a solar energy cell.

### Description of Related Art

Solar cells or voltaic cells are used to convert solar energy into electrical energy by so-called "photoelectric conversion mechanism". In recent years, solar energy has gained many research attentions for being a seemingly inexhaustible energy source. The electrical energy generated by the photovoltaic devices can be used for all kinds of purposes as those generated by batteries or existing power generators. Recently, along with the progresses and developments of photovoltaic technology, the cost of the photovoltaic devices drops noticeably and thus the photovoltaic devices are getting more and more popular on the market.

Due to the decorative or visual purposes, the solar cells are required to wear multi-color appearance. For example, when the solar cells are mounted on the roof or outer walls of a building, their colors should be matched with their environments.

However, conventional solar energy cells have electrical conductive channels located on their light-receiving sides, and the electrical conductive channels are approximate silver (because of containing silver pastes). Therefore, electrical conductive channels are different in color from other potions on the light-receiving side, e.g., anti-reflection layers, of the solar energy cell, thus sometimes resulting in color contrast or mismatch. Due to the decorative or visual purposes, if colors of the electrical conductive channels cannot match with colors of anti-reflection layers, the multi-colored anti-reflection layers cannot demonstrate its decorative or visual performance.

### SUMMARY

It is therefore an objective of the present invention to provide an improved solar energy cell.

In accordance with the foregoing and other objectives of the present invention, a solar energy cell includes a photoelectric conversion layer, an anti-reflection layer and a plurality of electrical conductive channels. The anti-reflection layer is disposed on the photoelectric conversion layer. The electrical conductive channels are disposed on the anti-reflection layer and are electrically connected with the photoelectric conversion layer, wherein the electrical conductive channels include a conductive paste and pigments to enable a color of the electrical conductive channels to be substantially the same as a color of the anti-reflection layer.

In another embodiment disclosed herein, the conductive paste includes silver powders, glass frits and organic vehicles.

In another embodiment disclosed herein, the pigments include organic pigments, inorganic pigments, synthetic pigments or any combinations thereof.

In another embodiment disclosed herein, the organic pigments include monazo, diazo, anthraquinone, indigoid phthalocyanine or any combinations thereof.

In another embodiment disclosed herein, the inorganic pigments include titanium dioxide, limonite, malachite, zinc oxide, manganese dioxide or any combinations thereof.

In accordance with the foregoing and other objectives of the present invention, a solar energy cell includes a photoelectric conversion layer, an anti-reflection layer and a plurality of electrical conductive channels. The anti-reflection layer is disposed on the photoelectric conversion layer and includes a plurality of different color sections. The electrical conductive channels are disposed on the anti-reflection layer and electrically connected with the photoelectric conversion layer, wherein each electrical conductive channel includes a conductive paste and pigments to enable a color of the electrical conductive channel to be substantially the same as a color of a corresponding one of the different color sections within which each electrical conductive channel is disposed.

In another embodiment disclosed herein, the conductive paste includes silver powders, glass frits and organic vehicles.

In another embodiment disclosed herein, the pigments include organic pigments, inorganic pigments, synthetic pigments or any combinations thereof.

In another embodiment disclosed herein, the organic pigments include monazo, diazo, anthraquinone, indigoid phthalocyanine or any combinations thereof.

In another embodiment disclosed herein, the inorganic pigments include titanium dioxide, limonite, malachite, zinc oxide, manganese dioxide or any combinations thereof.

Thus, the solar energy cell disclosed herein has its electrical conductive channel located on the light-receiving side to include proper pigments to enable its color to be substantially the same as a color of the entire anti-reflection layer or a color of a surrounding section of the anti-reflection layer according to actual demands, thereby achieving desired decorative or visual effects.

It is to be understood that both the foregoing general description and the following detailed description are by examples, and are intended to provide further explanation of the invention as claimed.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention. In the drawings,
Fig. 1 illustrates a top view of a solar energy cell according to one preferred embodiment of this invention;
Fig. 2 illustrates a cross-sectional view taken along the line 2-2' of Fig. 1; and
Fig. 3 illustrates a top view of a solar energy cell according to another preferred embodiment of this invention.

### DESCRIPTION OF THE PREFERRED EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

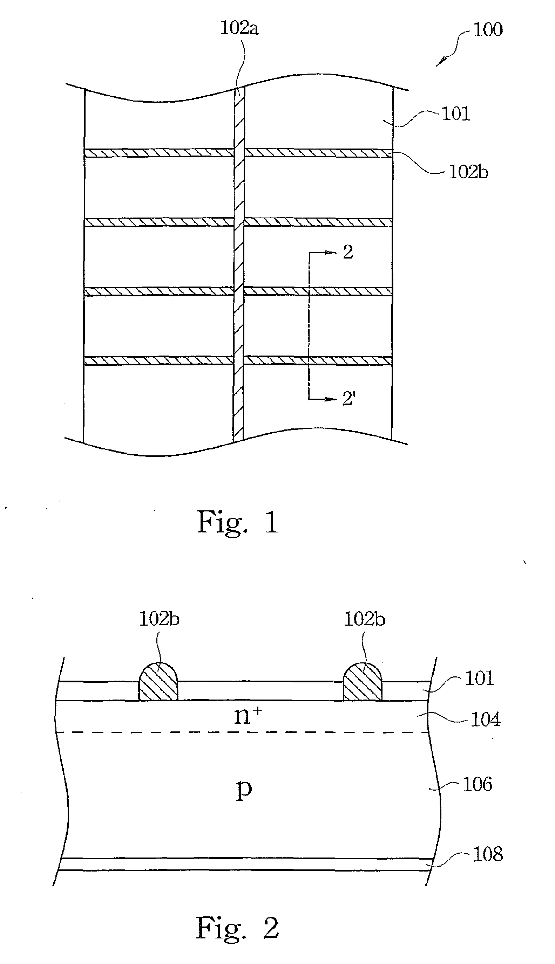

Referring to both Fig. 1 and Fig. 2, Fig. 1 illustrates a top view of a solar energy cell according to one preferred embodiment of this invention, and Fig. 2 illustrates a cross-sectional view taken along the line 2-2' of Fig. 1. A solar energy cell 100 includes a photoelectric conversion layer for converting solar energy into electrical energy. In this embodiment, the photoelectric conversion layer is formed from a N-type semiconductor layer 104 located on a P-type semiconductor substrate 106, such that a P-N conjunction with electric fields is formed therebetween. Therefore, when the P-N conjunction receives photons, positive charge carriers and negative charge carriers are generated, thereby producing electrical currents. This mechanism is also referred as a photoelectric conversion mechanism".

An anti-reflection layer 101 is formed on a light-receiving side of the N-type semiconductor layer 104 and the P-type semiconductor substrate 106 to reduce the reflective loss of the solar energy cell 100. In this embodiment, the anti-reflection layer 101 can be silicon nitride or silicon oxide deposited thereon by evaporation, sputtering, screen printing, chemical vapor deposition or other techniques known by those skilled in the art. In this embodiment, the anti-reflection layer 101 is formed over the photoelectric conversion layer according to a desired color. In particular, a thickness of the anti-reflection layer 101 is determined according to the desired color. In addition, one or more electrical conductive channels 108 are formed on a bottom side of the N-type semiconductor layer 104 and the P-type semiconductor substrate 106 to output electrical current generated by the photoelectric conversion layer. A plurality of electrical conductive channels (102a, 102b) are formed over the anti-reflection layer 101 and electrically connected with the N-type semiconductor layer 104. The electrical conductive channels 102b of a smaller cross-section collect and transfer electrical current to the electrical conductive channels 102a of a larger cross-section for external uses. The electrical conductive channels (102a, 102b) are made from conductive pastes and pigments to enable their colors to be the same as a color of the anti-reflection layer 101 such that the light-receiving side of the solar energy cell can be of the same color to enhance decorative or visual purposes. For example, when the anti-reflection layer 101 is of blue color, the electrical conductive channel can include pigments to become a blue electrical conductive channel.

Fig. 2 only illustrates a cross-sectional design related to the present invention, and other conventional structures, e.g., waterproof designs or front glass, are omitted.

In this embodiment, the conductive paste can include silver powders, glass frits and organic vehicles, but is not limited to those ingredients. The pigments can be organic pigments, inorganic pigments, synthetic pigments or any combinations thereof. The organic pigments can be monazo, diazo, anthraquinone, indigoid, phthalocyanine or any combinations thereof. The inorganic pigments can be titanium dioxide, limonite, malachite, zinc oxide, manganese dioxide or any combinations thereof.

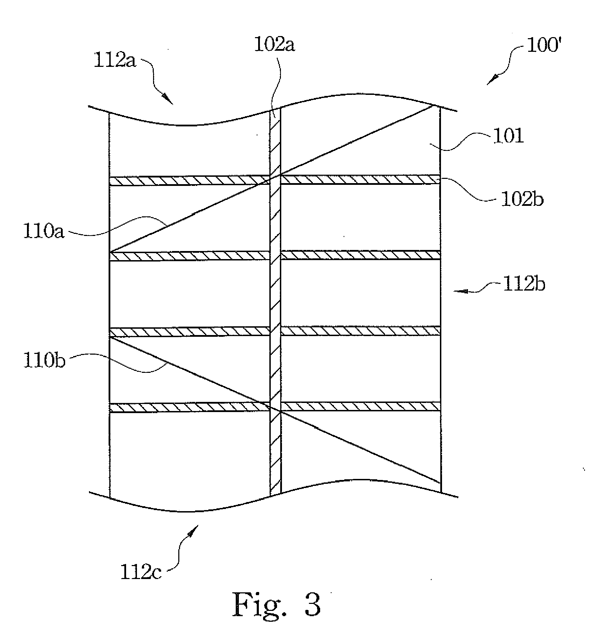

Referring to Fig. 3, which illustrates a top view of a solar energy cell 100' according to another preferred embodiment of this invention. The solar energy cell 100' is different from the solar energy cell 100 in that the solar energy cell 100' has several different color sections. In this embodiment, two border lines (110a, 110b) are used to divide the anti-reflection layer 101 into three sections (112a, 112b, 112c) of different colors.

The electrical conductive channels (102a, 102b) within the section 112a of the anti-reflection layer 101 can include proper pigments to enable a color of the electrical conductive channels to be substantially the same as the color of the section 112a.

The electrical conductive channels (102a, 102b) within the section 112b of the anti-reflection layer 101 can include proper pigments to enable a color of the electrical conductive channels to be substantially the same as the color of the section 112b.

The electrical conductive channels (102a, 102b) within the section 112c of the anti-reflection layer 101 can include proper pigments to enable a color of the electrical conductive channels to be substantially the same as the color of the section 112c.

The solar energy cell 100' may include only two different color sections or more than three different color sections according to actual demands so as to achieve desired decorative or visual effects.

In this embodiment, the conductive paste can include silver powders, glass frits and organic vehicles, but is not be limited to those ingredients. The pigments can be organic pigments, inorganic pigments, synthetic pigments or any combinations thereof. The organic pigments can be monazo, diazo, anthraquinone, indigoid, phthalocyanine or any combinations thereof. The inorganic pigments can be titanium dioxide, limonite, malachite, zinc oxide, manganese dioxide or any combinations thereof.

According to the above-discussed embodiments, the solar energy cell disclosed herein has its electrical conductive channel on the light-receiving side to include proper pigments to enable its color to be substantially the same as a color of the entire anti-reflection layer or a color of a surrounding section of the anti-reflection layer according to actual demands, thereby achieving desired decorative or visual effects.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A solar energy cell comprising:
a photoelectric conversion layer;
an anti-reflection layer disposed on the photoelectric conversion layer; and
a plurality of electrical conductive channels disposed on the anti-reflection layer and electrically connected with the photoelectric conversion layer, wherein the electrical conductive channels comprise a conductive paste and pigments to enable a color of the electrical conductive channels to be substantially the same as a color of the anti-reflection layer.

2. The solar energy cell of claim 1, wherein the conductive paste comprises silver powders, glass frits and organic vehicles.

3. The solar energy cell of claim 1, wherein the pigments comprise organic pigments, inorganic pigments, synthetic pigments or any combinations thereof.

4. The solar energy cell of claim 3, wherein the organic pigments comprise monazo, diazo, anthraquinone, indigoid phthalocyanine or any combinations thereof.

5. The solar energy cell of claim 3, wherein the inorganic pigments comprise titanium dioxide, limonite, malachite, zinc oxide, manganese dioxide or any combinations thereof.

6. The solar energy cell of any one of claims 1 to 5, wherein the anti-reflection layer comprises a plurality of different color sections, and wherein each electrical conductive channel comprises a conductive paste and pigments to enable a color of the electrical conductive channel to be substantially the same as a color of a corresponding one of the different color sections within which each electrical conductive channel is disposed.
